# DEMANDE DE BREVET EUROPEEN

(11) **EP 2 479 793 A1**
(43) Date de publication de la demande: **25.07.2012**
(21) Numéro de dépôt: 12354005.6
(22) Date de dépôt: 12.01.2012
(51) Int. Cl.: H01L 29/786, H01L 29/66

(54) **Procédé de fabrication d'un dispositif à effet de champ avec une faible capacité de jonction**

(30) Priorité: 24.01.2011 FR 1100201
(71) Demandeur: Commissariat à l'Énergie Atomique et aux Énergies Alternatives, 75015 Paris (FR)
(72) Inventeur: Vinet, Maud, 38140 Rives (FR); Grenouillet, Laurent, 38140 Rives (FR); Le Tiec, Yannick, 38920 Crolles (FR); Posseme, Nicolas, 29660 Carantec (FR)
(74) Mandataire: Talbot, Alexandre

(57) **Abrégé**

Le dispositif à effet de champ est formé sur un substrat de type semi-conducteur sur isolant muni d'un substrat de support (4) séparé d'un film semi-conducteur (6) par une couche électriquement isolante (5). Les électrodes de source (2) et de drain (3) sont formées dans le film semi-conducteur (6) de chaque côté de l'électrode de grille (1). La couche électriquement isolante (5) comporte une première zone (5a) ayant une première valeur de capacité électrique entre le film semi-conducteur (6) et le substrat de support (4) face à l'électrode de grille (1). La couche électriquement isolante (5) comporte des deuxième et troisième zones (5b, 5c) ayant une valeur de capacité électrique supérieure à la première valeur entre le film semi-conducteur (6) et le substrat de support (4) face aux électrodes de source et de drain (2, 3).

## Description

### Domaine technique de l'invention

L'invention est relative à un procédé de fabrication d'un dispositif à effet de champ intégré sur un substrat de type semi-conducteur sur isolant.

### État de la technique

L'utilisation de transistors à effet de champ formés sur des substrats de type silicium sur isolant présente de nombreux avantages, notamment, une simplification du dessin des circuits intégrés et une amélioration des performances des dispositifs.

Par ailleurs, l'engouement pour ce type d'architecture provient également du fait que les schémas d'intégration du transistor ne sont presque pas modifiés car seul le substrat a été remplacé ce qui permet de conserver un procédé de fabrication maîtrisé.

Afin de satisfaire des contraintes technologiques toujours plus importantes, les transistors utilisés sont de plus en plus petits et les substrats utilisés ont des épaisseurs de silicium et d'oxyde enterré de plus en plus fines. Cette modification des paramètres du substrat doit normalement permettre une bonne maîtrise de l'abaissement de barrière induite par le drain qui est un effet parasite lié à la propagation des lignes de champ dans le transistor.

Cependant, l'utilisation d'un transistor intégré sur un film électriquement isolant de plus en plus mince présente également de nombreux inconvénients. Au fur et à mesure de la diminution des dimensions du transistor, il y a une augmentation des composantes parasites du transistor. Cette augmentation des composantes parasites a pour principal effet de réduire la vitesse de fonctionnement du circuit et donc de réduire les bénéfices liés à la réduction des dimensions du transistor.

Il en ressort que, dans sa configuration actuelle, le transistor sur isolant ne paraît plus aussi avantageux car les gains en performance sont limités, notamment du point de vue dynamique.

Le document US2007/0246752 décrit la réalisation d'un dispositif à effet de champs muni d'un trou séparant les électrodes de source et de drain du support. Le trou est formé au moyen d'un matériau poreux qui permet l'élimination du matériau sacrificiel se trouvant initialement sous les électrodes de source et de drain. Un tel dispositif est difficile à mettre en oeuvre car il est limité à un nombre restreint de matériaux.

Le document US2008/0265323 décrit également la réalisation d'un dispositif à effet de champs muni d'un trou séparant les électrodes de source et de drain du support. Un premier substrat est gravé pour former des trous et une couche active est déposée de manière à fermer les trous. Les zones de source et de drain sont ensuite formées au dessus des trous. Ce mode de réalisation reste très théorique car il existe de nombreuses contraintes d'alignement des électrodes par rapport aux cavités et de nombreuses difficultés de réalisation lors du dépôt de la couche active.

### Résumé de l'invention

On constate qu'il existe un besoin de prévoir un procédé de fabrication d'un dispositif à effet de champ plus performant qui soit facile à mettre en oeuvre et qui soit facilement co-intégrable avec les procédés de réalisation des circuits électroniques.

Le dispositif est réalisé selon un procédé comprenant les étapes suivantes :
- prévoir un substrat muni successivement d'un substrat de support, une couche électriquement isolante avec une première constante diélectrique, un film en matériau semi-conducteur, un matériau diélectrique de grille, une électrode de grille, une zone de source et une zone de drain, les zones de source et de drain étant séparées par l'électrode de grille,
- éliminer partiellement la couche électriquement isolante entre le substrat de support et le film semi-conducteur de manière à former des zones de source et de drain suspendues et maintenues par une première zone de maintien mécanique entre le film semi-conducteur et le substrat de support le long de l'électrode de grille,
- déposer un matériau électriquement isolant entre les zones de source et drain et le substrat de support de manière à former des zones ayant une constante diélectrique plus faible que la zone de maintien entre le substrat de support et le film semi-conducteur.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1 illustre, en coupe, de manière schématique, un mode de réalisation particulier d'un transistor sur isolant,
- les figures 2 à 5 illustrent, en coupe, de manière schématique, un mode de mise en oeuvre particulier d'un transistor sur isolant,
- la figure 6 illustre, en coupe, de manière schématique, une variante de mise en oeuvre d'un transistor sur isolant.

### Description d'un mode de réalisation préféré de l'invention

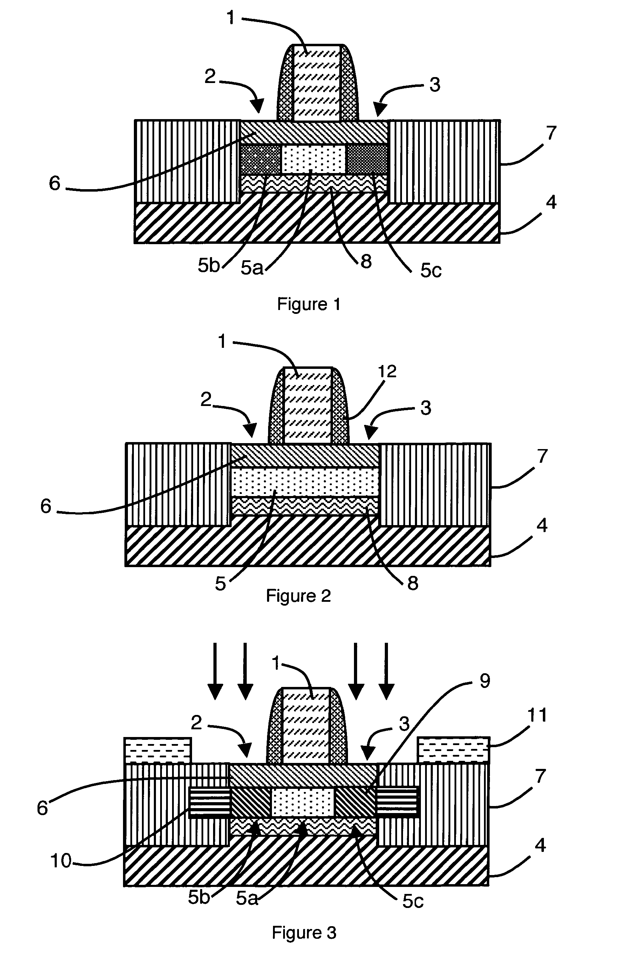

Comme illustré à la figure 1, le transistor comporte une électrode de grille 1, une électrode de source 2 et une électrode de drain 3. Le transistor est réalisé sur un substrat de type semi-conducteur sur isolant qui comporte un substrat de support 4, une couche électriquement isolante 5 et un film semi-conducteur 6 dit actif sur lequel est formé le transistor. Le substrat de support 4 est séparé du film semi-conducteur 6 par la couche électriquement isolante 5.

L'électrode de grille 1 est séparée du film semi-conducteur 6 par un matériau diélectrique de grille (non représenté). Le diélectrique de grille est un matériau électriquement isolant, par exemple un oxyde de silicium, un nitrure de silicium ou un matériau présentant une plus grande constante diélectrique que ces derniers comme l'oxyde d'hafnium.

Les électrodes de source 2 et de drain 3 sont disposées de part et d'autre de l'électrode de grille 1 et elles sont formées au moins partiellement dans le film semi-conducteur 6. Dans le film semi-conducteur 6, les électrodes de source 2 et de drain 3 sont séparées par un canal de conduction qui est disposé directement en dessous de l'électrode de grille 1. Dans certains modes de réalisation, il est envisageable d'épaissir le film semi-conducteur 6 au niveau des zones de source et de drain par une étape d'épitaxie sélective. Un matériau semi-conducteur de même nature que le film semi-conducteur ou un matériau de nature différente est déposé sur les zones de source/drain.

Dans certains modes de réalisation où le transistor est réalisé avec d'autres dispositifs actifs sur le substrat, le transistor est isolé électriquement du reste du substrat au moyen d'un motif d'isolation 7. Le motif d'isolation 7 est réalisé dans un matériau électriquement isolant qui entoure le transistor. Le motif d'isolation 7 s'enfonce dans le film semi-conducteur 6. Il peut également s'enfoncer dans la couche électriquement isolante 5 et dans le substrat de support 4. Dans un plan de coupe parallèle à l'interface entre le substrat de support 4 et la couche électriquement isolante 5, le motif d'isolation 7 définit un motif périphérique fermé à l'intérieur duquel est définie une zone active dans le film semi-conducteur 6. Cette zone active contient l'électrode de source, l'électrode de drain et le canal de conduction.

Afin d'obtenir un dispositif ayant des performances électriques améliorées, la couche électriquement isolante 5 présente des zones distinctes. Ces zones distinctes forment différents condensateurs. Il y a un premier condensateur dont les électrodes sont formées par le canal et le substrat de support 4 et sont séparées par la couche électriquement isolante 5. Des deuxième et troisième condensateurs sont présents et comportent successivement le substrat de support 4, la couche électriquement isolante 5 et les électrodes de source ou de drain 3.

La valeur de la capacité de couplage est mesurée entre le substrat de support 4 et le film semi-conducteur 6 dans les portions se faisant face. La valeur de la capacité de couplage prend en compte les différents matériaux que l'on trouve entre le substrat de support 4 et le film semi-conducteur 6 ainsi que leur épaisseur. La couche isolante 5 peut être découpée en trois zones, chaque zone étant associée à un condensateur et donc à une partie spécifique transistor et du film semi-conducteur. La valeur de la capacité de couplage prend également en compte la surface des électrodes se faisant face.

Une première zone 5a est disposée face à l'électrode de grille 1, ici sous l'électrode de grille et donc sous le canal de conduction. La première zone 5a présente une première valeur de constante diélectrique ou permittivité entre le substrat de support et le film semi-conducteur 6. La première zone 5a fait partie du premier condensateur avec une première valeur de capacité de couplage par unité de surface.

Une deuxième zone 5b est disposée face à l'électrode de source 2 et elle présente une deuxième valeur de constante diélectrique. La deuxième zone 5b fait partie du deuxième condensateur avec une deuxième valeur de capacité de couplage par unité de surface. La deuxième valeur de capacité de couplage par unité de surface est inférieure à la première valeur de capacité de couplage par unité de surface. Cette différence entre les première et deuxième valeurs de capacité de couplage peut provenir du fait que la valeur de la constante diélectrique de la couche électriquement isolante 5 dans la deuxième zone est inférieure à la première valeur de constante diélectrique dans la première zone 5a, la distance séparant les électrodes étant identique entre les zones 5a et 5b. Cette différence peut provenir également du fait que la distance qui sépare les deux électrodes est plus importante dans la seconde zone 5b que dans la première 5a, le matériau formant la couche électriquement isolante étant identique dans les première et deuxième zones 5a et 5b. Cette différence de capacité de couplage peut provenir encore d'une combinaison des deux cas précédents.

Une troisième zone 5c est disposée face à l'électrode de drain 3 et elle présente une troisième valeur de capacité de couplage par unité de surface. La troisième valeur de capacité de couplage par unité de surface est inférieure à la première valeur de capacité de couplage par unité de surface. La différence entre les première et troisième valeurs de capacité de couplage par unité de surface peut provenir des mêmes raisons que celles expliquées plus haut pour la deuxième capacité de couplage.

Dans la suite de la description, le terme capacité de couplage par unité de surface est remplacé par le terme capacité de couplage. La capacité de couplage par unité de surface correspond au rapport entre la permittivité du diélectrique présent entre les deux électrodes du condensateur et la distance qui sépare les électrodes. Cette architecture permet de diminuer la capacité de couplage (en modifiant la capacité de couplage par unité de surface) sans modifier le dessin du transistor.

La différence de capacité de couplage est observée entre le film semi-conducteur 6 et le substrat de support 4, c'est-à-dire qu'elle provient d'une différence d'épaisseur entre les zones en regard et/ou d'une différence de matériau utilisé entre les deux électrodes du condensateur ce qui se traduit par une différence du rapport permittivité sur épaisseur (ε/e).

L'utilisation d'un transistor ayant une capacité plus faible sous les électrodes de source 2 et drain 3 comparée à ce qui est présent sous l'électrode de grille 1 permet de réduire le couplage électrostatique entre les électrodes de source/drain et le substrat et donc d'obtenir un transistor plus rapide qu'avec un film isolant 5 homogène. La conservation d'une capacité plus élevée sous le canal de conduction permet de garder un couplage électrostatique important avec le substrat de support 4. Cette configuration est particulièrement intéressante par exemple lorsqu'une contre-électrode est utilisée dans le substrat de support 4. Cette architecture permet simultanément de diminuer les capacités parasites au niveau des électrodes de source 2 et de drain 3 tout en faisant bénéficier le transistor d'une bonne maîtrise des effets de canaux courts et des effets de modulation de tension de seuil. Cette architecture permet d'améliorer les performances dynamiques du transistor sans dégrader ses performances statiques.

La couche électriquement isolante 5 peut être formée par un seul matériau qui est présent entre le substrat de support 4 et le film semi-conducteur 6 en face des différentes électrodes. Le matériau présente alors des épaisseurs variables de manière à avoir un couplage plus faible au niveau des électrodes de source/drain comparé au couplage dans le canal de conduction.

La couche électriquement isolante 5 peut également être formée par un empilement de plusieurs couches avec des épaisseurs variables selon les zones afin d'obtenir une variation de la constante diélectrique globale. L'empilement de couches a lieu dans une direction qui relie la couche de support 4 au film semi-conducteur 6.

Il est possible de combiner les deux modes de réalisation précédents afin d'avoir une couche électriquement isolante comportant différents constituants et différents matériaux sous la grille 1 et sous les électrodes de source/drain.

Dans encore un autre mode de réalisation qui peut être combiné aux précédents, la variation de capacité peut également provenir de l'utilisation de matériaux différents selon les condensateurs. Ainsi, à titre d'exemple, un premier matériau électriquement isolant est utilisé sous l'électrode de grille 1 avec une première constante diélectrique. Ce premier matériau forme la couche électriquement isolante dans la zone 5a. Un deuxième matériau électriquement isolant est utilisé sous l'électrode de source 2 et forme la couche électriquement isolante dans la zone 5b. Un troisième matériau électriquement isolant est utilisé sous l'électrode de drain 3 et forme la couche électriquement isolante dans la zone 5c. Il y a alors un empilement de couches dans une direction parallèle à l'axe reliant l'électrode de source 2 à l'électrode de drain 3. Les deuxième et troisième matériaux sont choisis de manière à avoir une constante diélectrique inférieure à celle du premier matériau si l'épaisseur entre les trois zones est identique.

Dans un mode particulier de réalisation, l'épaisseur de la couche électriquement isolante 5 est constante et il y a des matériaux différents qui sont utilisés pour définir les différentes zones 5a, 5b et 5c. Dans un cas particulier de réalisation, les zones 5b et 5c sont formées par le même matériau et la zone 5a est formée par un autre matériau.

Selon les modes de réalisation employés, la différence de capacité entre les différentes zones 5a, 5b et 5c peut provenir de l'utilisation de plusieurs couches ayant des constantes diélectriques différentes. La différence de capacité peut encore être obtenue en utilisant des films identiques mais avec des épaisseurs différentes. Comme indiqué plus haut, il est également possible de combiner ces deux modes de réalisation.

Dans un mode de réalisation privilégié, la valeur de la seconde capacité est égale à celle de la troisième capacité (à surfaces égales). Ces deux zones peuvent alors avoir des matériaux identiques avec la même épaisseur ou des épaisseurs différentes avec des matériaux compensant cette différence d'épaisseur.

Dans un mode de réalisation encore plus privilégié qui peut être combiné avec le mode précédent, la deuxième 5b et/ou la troisième zone 5c peut comporter une zone vide ou être constituée par une zone vide. L'utilisation d'une zone vide permet d'obtenir facilement une faible constante diélectrique et donc un faible couplage face aux électrodes de source 2 et drain 3. La zone vide est une zone isolante qui peut être formée par un élément gazeux avec une pression prédéterminée, par exemple un gaz à pression sub-atmosphérique. L'électrode de source et/ou l'électrode de drain est alors suspendue au-dessus du substrat de support 4 et la zone 5a sert de zone de maintien mécanique.

Dans un mode de réalisation qui peut être combiné avec les modes de réalisation précédents, le substrat de support 4 comporte une contre-électrode 8 qui est formée en face de l'électrode de grille 1 et avantageusement en face des électrodes de source 2 et de drain 3. La contre-électrode 8 permet de modifier le fonctionnement du transistor en modulant le couplage avec le canal de conduction.

De manière avantageuse, le motif d'isolation 7 entoure le transistor et bouche l'accès à la deuxième 5b et/ou à la troisième 5c zones lorsque celle-ci est vide. La zone vide est délimitée par le substrat de support 4 et le film semi-conducteur 6. Elle est délimitée latéralement par la première zone 5a et par le motif d'isolation 7 au moyen d'une paroi latérale du motif d'isolation 7 qui relie le film semi-conducteur 6 au substrat de support 4. Cette paroi latérale est préférentiellement plane. Cette configuration ne permet pas d'avoir accès à la zone vide tout au long du procédé de mise en oeuvre ce qui augmente la fiabilité du transistor en réduisant les risques de pollution parasite coincée dans la zone vide. Il peut en être de même lorsque la deuxième 5b et/ou la troisième 5c zones comporte un volume vide, par exemple lorsque les zones 5b et/ou 5c sont formées en partie par un matériau solide isolant et par un volume vide.

Le transistor peut être obtenu simplement de la manière suivante. Comme illustré à la figure 2, le transistor est réalisé de manière conventionnelle jusqu'à la formation de l'électrode de grille 1 ou des électrodes de source 2 et de drain 3 par implantation. Le film semi-conducteur 6 comporte une zone de source 2 et une zone de drain 3 séparées par l'électrode de grille 1. La zone de source peut également porter le nom d'électrode de source si elle est dopée. Il en va de même de la zone de drain.

De cette manière, le substrat de type semi-conducteur sur isolant comporte à sa surface une électrode de grille 1. L'électrode peut être associée à un motif d'isolation 7 afin de délimiter une zone active dans le film semi-conducteur 6 et éventuellement dans la couche électriquement isolante 5.

Dans un premier mode de mise en oeuvre illustré à la figure 3, la couche électriquement isolante 5 est modifiée par implantation pour former deux matériaux différents présentant entre eux une sélectivité de gravure. Il y a formation d'un matériau sacrificiel 9 par implantation.

Dans ce cas de figure, un matériau nouveau est formé sous les zones découvertes. Le matériau sacrificiel 9 est formé par implantation dans le matériau formant initialement la couche électriquement isolante 5. Après l'étape d'implantation, il y a dans la couche 5 des zones en matériau sacrificiel 9 et des zones en matériau à conserver.

Le masque d'implantation utilisé définit les dimensions et les positions des zones à éliminer et des zones à conserver. Le masque d'implantation peut, par exemple, être formé par une résine photosensible 11 ou par un autre matériau. Le masque d'implantation peut également être formé par la grille 1.

Les zones vides du masque définissent les zones à éliminer et les zones pleines les zones à conserver. Dans ce premier mode de réalisation, il est intéressant de conserver le matériau initial de la couche 5 sous l'électrode de grille 1 pour former la zone 5a.

Si le masque d'implantation est formé par une résine, il est avantageux de disposer le masque au-dessus de la grille et de recouvrir la grille afin de définir une zone 5a plus large que la grille.

Dans un mode de réalisation particulier illustré également à la figure 3, l'étape d'implantation forme également un matériau sacrificiel additionnel 10 dans le motif d'isolation 7

Dans une variante de réalisation, l'électrode de grille 1 est utilisée comme masque d'implantation. Il est avantageux d'utiliser l'électrode de grille 1 comme masque d'implantation car cela permet d'avoir un auto-alignement de l'électrode de grille avec la première zone 5a. Selon les modes de réalisation, l'implantation peut être réalisée avec un angle d'implantation nul ou non nul. L'implantation avec un angle nul permet de définir une zone 5a ayant les mêmes dimensions que l'électrode de grille 1 avec éventuellement ses espaceurs latéraux 12. L'implantation avec un angle non nul permet de réduire les dimensions de la zone 5a par rapport aux dimensions physiques de l'électrode de grille 1 et ainsi tenir compte de la diffusion des dopants, par exemple sous les espaceurs latéraux 12.

Dans une variante de réalisation illustrée à la figure 3, le masque d'implantation est réalisé en partie par l'électrode de grille 1 et en partie par la résine 11. A titre d'exemple, la résine 11 forme un motif au-dessus du motif d'isolation 7 afin de limiter l'étendue du matériau sacrificiel additionnel 10 dans le motif d'isolation 7 tout en conservant l'auto-alignement de la première zone 5a par rapport à la grille 1.

Les dimensions latérales de la première zone 5a sont fonctions de l'angle d'implantation, de la taille de l'électrode de grille 1 (ou du masque d'implantation) et de l'utilisation d'espaceurs latéraux 12, le cas échéant.

Le matériau implanté dans la couche électriquement isolante permet d'obtenir une sélectivité de gravure du matériau sacrificiel 9 par rapport aux autres matériaux présents. A titre d'exemple, pour une couche électriquement isolante 5 en oxyde de silicium, une implantation d'arsenic ou d'indium est réalisée afin de former un oxyde de silicium dopé qui se grave à une vitesse plus importante que l'oxyde de silicium non dopé. La gravure est avantageusement réalisée au moyen d'acide fluorhydrique, préférentiellement sous forme de HF anhydre gazeux.

Dans le cas où le motif d'isolation 7 est dans le même matériau que la couche électriquement isolante 5, le matériau sacrificiel 9 et le matériau sacrificiel additionnel 10 sont identiques et réagissent à la même chimie de gravure. Il est alors possible de former un chemin de dégradation préférentiel du matériau sacrificiel 9 en passant par le motif d'isolation 7. L'étendue de la gravure parasite dans le motif d'isolation 7 est liée à la sélectivité de gravure qui existe entre le matériau sacrificiel 9 et aux matériaux formant le motif d'isolation 7 et par rapport à la zone 5a.

Quand l'électrode de grille 1 est utilisée en tant que masque, il est avantageux de réaliser l'opération de formation du matériau sacrificiel 9 en même temps que la formation des électrodes de source 2 et de drain 3, si le matériau dopant est implanté avec une concentration telle qu'il autorise la formation du matériau sacrificiel 9.

Dans ce cas de figure, après l'étape d'implantation, la zone 5a est disposée sous l'électrode de grille 1 et elle possède sensiblement les dimensions latérales de l'électrode de grille 1. La zone 5a correspond au volume de la couche isolante 5 qui n'a pas été implantée. Une autre partie de la couche 5 en matériau sacrificiel 9 correspond aux zones 5b et 5c et elle est disposée sous les électrodes de source 2 et de drain 3.

Ces deux portions sont formées par des matériaux différents et elles réagissent à des chimies de gravure différentes et/ou à la même chimie de gravure mais avec des vitesses différentes de manière à obtenir une certaine sélectivité de gravure.

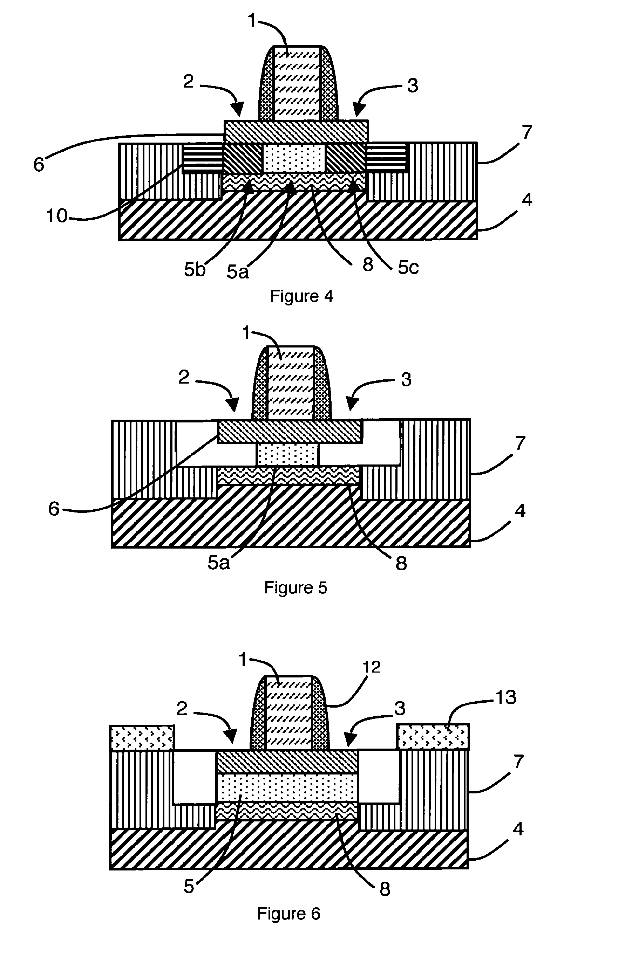

Comme cela est illustré aux figures 4 et 5, un premier trou est formé dans le motif d'isolation 7 et/ou dans le film semi-conducteur 6 pour avoir accès à la seconde zone 5b de la couche électriquement isolante 5. Un second trou est formé dans le motif d'isolation et/ou dans le film semi-conducteur 6 pour avoir accès à la troisième zone 5c de la couche électriquement isolante 5.

Dans le mode de réalisation illustré à la figure 4, le trou est formé par l'élimination complète du motif d'isolation 7 sur une partie de son épaisseur, de manière à atteindre le matériau sacrificiel 9 et/ou le matériau sacrificiel additionnel 10. Dans l'exemple illustré, la partie supérieure du motif d'isolation 7 est éliminée de manière isotrope ou anisotrope pour permettre l'accès au matériau sacrificiel additionnel 10 qui donnera ensuite accès au matériau sacrificiel 9.

Dans le mode de réalisation illustré à la figure 5, le trou est formé par l'élimination d'une partie de la surface du motif d'isolation 7 pour atteindre le matériau sacrificiel 9 et/ou le matériau sacrificiel additionnel 10. Dans l'exemple illustré, seule une partie du motif d'isolation 7 est accessible et gravée. Cette gravure localisée est obtenue par exemple au moyen d'un masque de gravure associé à une gravure anisotrope, mais une gravure isotrope est également possible.

La forme et la surface du trou sont quelconques dans la mesure où le trou autorise l'accès à la zone sacrificielle.

En variante, il est également envisageable de ne former qu'un seul trou qui donne accès simultanément aux deux zones 5b et 5c. Dans un mode de mise en oeuvre particulier, le motif d'isolation 7 est éliminé autour du transistor jusqu'à atteindre les seconde 5b et troisième 5c zones de la couche d'isolation 5.

De préférence, le trou est formé dans le motif d'isolation 7 car cela permet de relâcher les contraintes dimensionnelles et d'alignement pour assurer un accès à la couche électriquement isolante 5. Lorsque le trou est formé dans le motif d'isolation 7 ou par élimination du motif d'isolation 7, il est préférable de former le matériau sacrificiel additionnel 10 ce qui permet d'avoir une plus grande souplesse dans le procédé de dégradation à venir.

Dans une autre variante de réalisation, il est envisageable de former des électrodes de source/drain qui sont partiellement en silicium ou siliciure poreux afin d'autoriser l'accès à la couche sacrificielle sans former de trou dans le motif d'isolation 7, ni dans les électrodes de source/drain.

Comme cela est illustré à la figure 5, une fois que la seconde 5b et la troisième 5c zones de la couche d'isolation 5 sont accessibles, ces deux zones sont éliminées au moyen d'une chimie de gravure adaptée.

De cette manière, la première zone 5a est conservée entre l'électrode de grille 1 et le substrat de support 4 et les deuxième 5b et troisième 5c zones sont formées par des zones vides. La première zone 5a forme une zone de maintien mécanique qui permet aux zones de source 2 et de drain 3 d'être suspendues au-dessus du substrat de support 4. Les zones suspendues sont de chaque côté de la zone de maintien 5a. Grâce à la sélectivité de gravure qui existe entre le matériau sacrificiel et le matériau à conserver, la zone de maintien est disposée face à l'électrode de grille 1, le long de l'électrode de grille. La zone de maintien supporte au moins partiellement le transistor durant tout le procédé.

Dans une variante de réalisation, l'élimination des seconde 5b et la troisième 5c zones de la couche d'isolation 5 est réalisée par toute technique adaptée, par exemple au moyen d'une dégradation thermique ou d'une dégradation par un rayonnement électromagnétique ou électronique. A titre d'exemple, ces techniques sont utilisées pour former des structures d'interconnexion avec des cavités d'air (air-gap en anglais). Le trou formé sert alors à l'évacuation du sous-produit de dégradation.

Dans encore une autre variante, le trou n'est pas nécessaire si un matériau électriquement isolant poreux est présent dans la zone d'isolation 7 et permet le passage d'un agent de dégradation et/ou du sous-produit de dégradation vers la couche électriquement isolante 5. A titre d'exemple, deux catégories de matériaux peuvent être envisagées, des oxydes de silicium dopés par de l'hydrogène, du carbone ou du fluor et qui sont typiquement notés sous la forme SiOCH, SiCH ou SiOF et des polymères organiques poreux ne contenant pas de silicium tels que des matériaux à base de carbone, par exemple une matrice carbone qui est dopée par de l'hydrogène et notée CH ou une matrice carbone dopée par du fluor et notée CF.

Il est également possible d'utiliser un matériau perméable à l'agent de dégradation et/ou au sous-produit de dégradation à la place du trou et du matériau poreux. Le matériau poreux ou perméable évite la formation d'un trou ce qui permet de conserver une fiabilité élevée du dispositif.

Une fois la couche électriquement isolante 5 partiellement éliminée, ici avec l'élimination du matériau sacrificiel 9, elle présente des zones avec des constantes diélectriques différentes selon les critères définis plus haut.

Le dispositif à effet de champ est isolé électriquement du substrat de support 4 et les électrodes de source/drain n'ont pas, en vis-à-vis, le même matériau diélectrique que le canal de conduction.

Dans ce mode de réalisation, les portions du film semi-conducteur formant les électrodes de source et de drain sont suspendues. Cette configuration permet de relâcher au moins partiellement les contraintes présentes initialement ou induites par le procédé de fabrication. Le film semi-conducteur est maintenu en suspension au moyen de la partie de la couche électriquement isolante qui est face au canal ce qui permet de maintenir le jeu de contraintes dans le canal de conduction.

La relaxation du jeu de contraintes peut être complète ou presque complète si le motif d'isolation 7 est gravé de manière à réduire son épaisseur autour de la zone active du transistor pour accéder à la couche électriquement isolante. Les parois latérales du film semi-conducteur sont libres. La relaxation du jeu de contraintes peut être partielle si l'accès à la couche électriquement isolante est obtenu au moyen d'un trou formé dans le motif d'isolation 7 ou dans le film semi-conducteur 6 qui limite les éventuelles déformations du film semi-conducteur pour se relaxer. Il peut également y avoir transformation ou conservation du jeu de contraintes initiales si l'accès à la couche électriquement isolante 5 est obtenue grâce à un matériau poreux, le motif d'isolation 7 restant en contact du film semi-conducteur 6.

Dans un mode particulier de mise en oeuvre, il est ensuite possible de remplir les zones vides par un matériau isolant additionnel différent du matériau constituant la zone 5a, de manière à renforcer la fiabilité électrique et la stabilité mécanique de la structure tout en conservant de bonnes propriétés électrostatiques. Ce matériau isolant additionnel est, par exemple, un matériau dont la constante diélectrique est inférieure à celle de l'oxyde de silicium comme, avantageusement, un matériau poreux. Le matériau isolant additionnel est par exemple déposé à la tournette.

Lorsque la zone vide est remplie par un nouveau matériau, il est possible d'introduire un nouveau jeu de contraintes dans les électrodes de source 2 et de drain 3 et dans une moindre mesure dans le canal de conduction. Au moyen de ce mode de réalisation, il est alors possible de former un transistor avec un jeu de contraintes complexe. Le canal et les électrodes de source/drain sont soumis à des jeux de contraintes différents. Ce mode de réalisation permet de co-intégrer simplement deux transistors ayant des jeux de contraintes différents.

Ce mode de réalisation est particulièrement intéressant car il permet facilement de délimiter les zones à éliminer et de réaliser l'auto-alignement par rapport au canal de conduction. Ainsi, le jeu de contraintes peut rester symétrique par rapport au canal de conduction.

Dans un autre mode de mise en oeuvre qui peut être combiné aux modes précédents, il est possible de graver partiellement, le substrat de support 4 et/ou le film semi-conducteur 6 mis à découvert afin d'accroître la distance entre ces deux couches. L'augmentation de la distance permet de favoriser l'obtention d'une capacité plus faible sous les électrodes de source/drain comparée au canal de conduction dans le cas où le même matériau est présent en face du canal et des électrodes de source/drain. Il est également possible d'utiliser des matériaux différents pour avoir un effet plus marqué.

Comme indiqué plus haut, différentes techniques sont envisageables pour avoir un accès aux seconde et troisième zones de la couche d'isolation 5. Il est également possible de former un accès simultané aux deux zones 5b et 5c ou des accès consécutifs. Dans les modes de réalisation décrits ci-dessus, il y a un accès simultané aux zones 5b et 5c de manière à les vider durant la même étape technologique et éventuellement les remplir en même temps.

Il est également envisageable de les vider consécutivement en utilisant des masques différents pour accéder à la zone de source ou à la zone de drain. Il est encore possible d'utiliser un seul masque avec un bouchon qui masque une des deux zones.

Il est encore possible de remplir les zones, en même temps, avec le même matériau ou bien d'utiliser des matériaux différents. Si des matériaux différents sont utilisés entre la source et le drain, il est intéressant d'éliminer consécutivement les zones 5b et 5c pour les remplir au fur et à mesure ou d'utiliser un bouchon pour protéger une zone pendant que l'autre est remplie par l'isolant désiré. Ce mode de réalisation permet de former la zone 5b avec un matériau particulier et la zone 5c avec un matériau différent, comme cela est illustré à la figure 1. Le matériau déposé peut être ensuite structuré pour limiter sont étendue sous le transistor. Le motif d'isolation peut ensuite être reformé afin de ne présenter qu'un seul matériau isolant.

Le masque d'implantation peut également être utilisé en tant que masque de gravure lors d'une gravure anisotrope, par exemple en choisissant de graver le motif d'isolation 7 dans la zone découverte jusqu'à atteindre le matériau sacrificiel 9 et/ou le matériau sacrificiel additionnel 10.

De manière avantageuse, le trou qui a permis l'accès aux matériaux sacrificiels est rempli de façon à empêcher que des poussières ne restent coincées dans le trou ce qui est préjudiciable à la fiabilité du dispositif. Ce cas de figure est particulièrement intéressant lorsque l'accès à la couche électriquement isolante a été réalisé à travers le motif d'isolation 7 ce qui entraîne généralement la présence d'un trou de taille importante.

Dans un autre mode de réalisation illustré à la figure 6, il n'y a pas formation d'un matériau sacrificiel dans la couche électriquement isolante 5. Le substrat de départ est identique à celui illustré à la figure 2 et décrit plus haut. Un masque de gravure 13 est utilisé pour former un trou dans le motif d'isolation 7 et/ou dans le film semi-conducteur de manière à avoir accès à la couche électriquement isolante.

Un accès est formé du côté de la source 2, un autre accès est formé du côté du drain. Un agent de dégradation est ensuite envoyé à travers les trous pour éliminer en partie la couche électriquement isolante. Les conditions opératoires de l'étape de gravure sont choisies de manière à conserver le matériau initial de la couche électriquement isolante 5 sous le canal de conduction.

Ce mode de réalisation ne permet pas un auto-alignement de la zone 5a par rapport à l'électrode de grille 1 et donc par rapport au canal de conduction. La formation du masque de gravure est réalisée avec une autre étape de photolithographie que celle utilisée pour former l'électrode de grille 1. Cependant, ce mode de réalisation est simple à mettre en place car il comporte peu d'étapes additionnelles par rapport à un schéma d'intégration classique.

De manière préférentielle, le trou d'accès à la couche électriquement isolante 5 présente une surface d'apport en agent de dégradation parallèle aux faces latérales de l'électrode de grille 1 de manière à avoir un front de gravure parallèle à l'électrode de grille 1. Cette particularité permet d'avoir une zone 5a ayant une face latérale parallèle à la face latérale de la grille.

Une fois la dégradation partielle de la couche électriquement isolante 5 réalisée, la structure est identique à celle illustrée à la figure 5 et décrite plus haut. Il est alors possible de modifier cette structure aux moyens des modes de réalisation déjà décrit en relation avec la figure 5.

Dans ce mode de réalisation, il est également possible de ne pas former de trou, mais d'utiliser un matériau poreux ou perméable à l'agent de dégradation de manière à avoir élimination du matériau constituant la couche électriquement isolante 5.

Dans un mode de réalisation préférentiel, le motif d'isolation 7 comporte une partie supérieure en matériau poreux ou perméable qui forme l'accès à la couche électriquement isolante 5. Il y a alors dégradation partielle de la couche électriquement isolante de manière à former la zone 5a sans qu'il soit possible à des poussières de passer à travers le motif d'isolation pour s'introduire dans les zones vides.

Dans ce cas de figure, une partie du motif d'isolation et/ou du film semi-conducteur 6 est en matériau poreux ou perméable à l'agent de dégradation. Comme précédemment, pour avoir un front de gravure parallèle à la paroi latérale de la grille, il est avantageux que le matériau poreux ou perméable présente une face adjacente qui est parallèle à l'axe longitudinal de l'électrode de grille.

Dans un mode de réalisation particulier qui peut être combiné aux modes précédents, les électrodes de source/drain sont siliciurées avant d'éliminer partiellement la couche électriquement isolante 5. Cet enchaînement d'étapes permet de protéger le matériau servant pour la prise des contacts et ainsi préserver un bon fonctionnement du transistor.

Le motif d'isolation 7 peut être formé par un matériau qui réagit ou non à l'agent de dégradation du matériau sacrificiel 9. Si le motif d'isolation 7 est réalisé dans un matériau résistant à l'agent de gravure, un trou est formé ou un matériau poreux/perméable est utilisé afin d'autoriser l'accès à la couche électriquement isolante 5. Il est alors avantageux de former un matériau sacrificiel additionnel 10 qui permet d'avoir une marge de manoeuvre plus importante pour accéder à la couche électriquement isolante.

Si le motif d'isolation 7 est réalisé dans un matériau qui réagit avec l'agent de gravure. Il est avantageux de former un trou ou de limiter la zone de passage à travers le matériau poreux/perméable. Cette précaution permet de réduire la consommation du motif d'isolation 7 durant la gravure partielle de la couche électriquement isolante 5. Il est également avantageux de former un matériau sacrificiel additionnel 10 qui permet d'avoir une marge de manoeuvre plus importante pour accéder à la couche électriquement isolante et réduire la durée de l'étape de gravure.

## Revendications

1. Procédé de fabrication d'un dispositif à effet de champ **caractérisé en ce qu'**il comporte :
- prévoir un substrat muni successivement d'un substrat de support (4), une couche électriquement isolante (5) avec une première constante diélectrique, un film en matériau semi-conducteur (6), un matériau diélectrique de grille, une électrode de grille (1), une zone de source (2) et une zone de drain (3), les zones de source (2) et de drain (3) étant séparées par l'électrode de grille (1).
- éliminer partiellement la couche électriquement isolante (5) entre le substrat de support (4) et le film semi-conducteur (6) de manière à former des zones de source (2) et de drain (3) suspendues et maintenues par une première zone (5a) de maintien mécanique disposée le long de l'électrode de grille (1), entre le film semi-conducteur (6) et le substrat de support (4),
- déposer un matériau électriquement isolant entre les zones de source (2) et drain (3) et le substrat de support (4) de manière à former des zones (5b, 5c) ayant une constante diélectrique plus faible que la zone de maintien (5a) entre le substrat de support (4) et le film semi-conducteur (6).

2. Procédé selon la revendication 1, **caractérisé en ce que** le substrat comporte un motif d'isolation (7) entourant le film en matériau semi-conducteur (6) et la couche électriquement isolante (5) et **en ce qu'**il comporte l'élimination au moins partielle du motif d'isolation (7) pour permettre l'accès à la couche électriquement isolante (5) lors de son élimination.

3. Procédé selon l'une des revendications 1 et 2, **caractérisé en ce qu'**il comporte la formation de deux régions en matériau sacrificiel (9) dans la couche électriquement isolante (5) par implantation d'une impureté à travers le film en matériau semi-conducteur (6), les deux régions en matériau sacrificiel délimitant la première zone (5a) et étant éliminées pour former les deuxième et troisième zones (5b, 5c).

4. Procédé selon la revendication 3, **caractérisé en ce qu'**il comporte la formation d'un matériau sacrificiel additionnel (10) dans le motif d'isolation (7) en même temps que le matériau sacrificiel (9) pour former un chemin de gravure.

5. Procédé selon l'une quelconque des revendications 1 à 4, **caractérisé en ce que** le substrat comporte un matériau poreux ou perméable pour former l'accès à la couche électriquement isolante (5).
